# EUROPÄISCHE PATENTSCHRIFT

(11) **EP 0 476 634 B1**
(45) Veröffentlichungstag und Bekanntmachung des Hinweises auf die Patenterteilung: **14.08.1996**
(21) Anmeldenummer: 91115869.9
(22) Anmeldetag: 18.09.1991
(51) Int. Cl.: E06B 3/66, H01L 31/048

(54) **Bauelement, insbesondere Fassadenelement**
Building element, especially façade panel
Elément de construction, en particulier panneau de façade

(30) Priorität: 20.09.1990 DE 4029822
(43) Veröffentlichungstag der Anmeldung: 25.03.1992
(73) Patentinhaber: PILKINGTON Solar International GmbH, 50667 Köln (DE)
(72) Erfinder: Marquardt, Reinhold, Dr., W-4650 Gelsenkirchen (DE); Böhmer, Walter, W-4650 Gelsenkirchen (DE); Harzheim, Horst, W-5810 Witten (DE); Jäger, Wolfgang, W-5810 Witten (DE); Chehab, Oussama, W-4040 Neuss (DE); Rosendahl, Reiner, W-4150 Krefeld (DE)
(74) Vertreter: Goddar, Heinz J., Dr.

(56) Entgegenhaltungen:
- EP-A- 0 199 233
- EP-A- 0 328 049
- EP-A- 0 382 060
- DE-A- 2 033 764
- DE-A- 3 801 989
- DE-U- 8 909 018

## Beschreibung

Die Erfindung betrifft ein Bauelement, insbesondere ein Fassadenelement, mit einem außenseitigen Scheibenverbund, bei dem zwischen einer Außenscheibe und einer Innenscheibe Solarzellen angeordnet sind, und mit einer weiteren innenliegenden Scheibe, die mittels eines einen Innenraum definierenden Abstandhalterrahmens in einem Abstand zum Scheibenverbund vorgesehen ist.

Ein derartiges Bauelement ist aus der EP-A 0 382 060 bekannt und wird zum Verkleiden von Wänden und Dächern und auch für Fenster und Brüstungen verwendet. Insbesondere für den sich im Gebäude befindenden Betrachter sind solche Bauelemente jedoch oftmals ästhetisch nicht sehr gefällig, da die verwendeten Solarzellen weitgehend undurchsichtig sind.

Weiterhin ist es wünschenswert, daß die Bau- oder Fassadenelemente für eine hohe Schall- und Wärmedämmung sorgen. Dazu ist bei den bekannten Bauelementen vorgesehen, in den Raum zwischen dem außenseitigen Scheibenverbund und der innenliegenden Scheibe weitgehend zu evakuieren oder auch ein die Wärmestrahlung absorbierendes Edelgas einzubringen. Um die Wärmeabstrahlung ins Gebäudeinnere zu verhindern, wird auf die innere Oberfläche der Innenscheibe eine Low-E-Beschichtung als Wärmeschutzbeschichtung aufgetragen. Diese Maßnahmen bewirken, weiterhin abhängig von den Abmessungen des Baulements, insbesondere dem Abstand zwischen der Innenscheibe des Verbundes und der weiteren innenliegenden Scheibe, Wärmedurchgangswerte bis herab zu 1,3 W/m²K.

Es ist die Aufgabe der Erfindung, ein von außen und innen ästhetisch ansprechendes Bauelement mit hoher Schall- und Wärmedämmung zu schaffen, das einfach und wirtschaftlich hergestellt werden kann.

Diese Aufgabe wird von einem Bauelement der eingangs genannten Gattung mit den Merkmalen des Kennzeichens von Patentanspruch 1 oder Patentanspruch 2 gelöst. Vorteilhafte Ausgestaltungen sind Gegenstand der Unteransprüche.

Bei der Ausführungsform der Erfindung nach Patentanspruch 7 ist das Gießharz in bevorzugten Ausführungsformen entsprechend der Lehre der deutschen Patentanmeldung DE-A-40 33 545 ausgebildet. Bevorzugte Weiterbildungen der Erfindung nach den Patentansprüchen 8 und 9 sind entsprechend der europäischen Patentanmeldung EP-A-0 454 066 gestaltet.

Erfindungsgemäß sind die Solarzellen in einer Gießharzschicht eingebettet, weiterhin tritt die Innenscheibe in ihren Abmessungen im Bereich wenigstens einer Kante wenigstens teilweise in bezug auf die entsprechende Kante der Außenscheibe zurück und bildet so eine auch die Gießharzschicht übergreifende Ausnehmung, durch die die notwendigen elektrischen Leitungen für die Solarzellen geführt sind, wobei die Ausnehmung zum Innenbereich des Bauelements hin von dem Abstandhalterrahmen und der Innenraumabdichtung abgedeckt ist.

Alternativ tritt die Außenscheibe in ihren Abmessungen im Bereich wenigstens einer Kante wenigstens teilweise in bezug auf die entsprechende Kante zurück.

Durch das Einbetten der Solarzellen in eine Gießharzschicht entsteht ein wirtschaftlich herstellbarer Verbund, der zudem noch dadurch ausgezeichnet ist, daß die Solarzellen absolut lagestabil gehalten sind. Die stufige Ausgestaltung der Scheiben des Scheibenverbundes ermöglicht es, die Stromleitungen einfach und sicher aus dem Bauelement hinauszuführen. Da die Stufe von den ohnehin notwendigen Abstandhaltern verdeckt ist, wird die ästhetische Gesamtwirkung des Bauelementes nicht beeinträchtigt. Als Gießharz kommt insbesondere ein an sich bekanntes hochtransparentes Schalldämm-Gießharz auf Acrylatbasis in Frage. Da gute Schalldämmeigenschaften in der Regel auch mit guten Wärmdämmeigenschaften einhergehen, erhält man allein durch diese Maßnahmen ein sehr gut gedämmtes Bauelement.

Vorteilhaft ist die innenliegende Scheibe durch eine zweite Scheibe mit einer zwischengeschalteten Schicht aus Schalldämm-Gießharz zu einem innenseitigen Scheibenverbund ergänzt. Hierdurch werden nicht nur die ohnehin guten Dämmeigenschaften verbessert. Wenn ein lichtstreuendes Schalldämm-Gießharz verwendet wird, bewirkt dies einen Milchglaseffekt, wodurch die Sicht vom Gebäudeinneren auf die Rückseiten der Solarzellen im außenliegenden Verbund verhindert wird. Den gleichen Effekt erhält man, wenn bei Verwendung der innenliegenden Scheibe allein diese aus mattiertem Glas besteht oder wenn beim innenseitigen Scheibenverbund wenigstens eine der Scheibe mattiert ist.

Auch in die zwischengeschaltete Schicht können Solarzellen eingebettet sein, deren Absorptionsmaximum vorzugsweise für Sonnenlicht in einem von dem der Solarzellen des außenseitigen Scheibenverbundes unterschiedlichen Spektralbereich liegt. Sinnvollerweise sind die Solarzellen des innenseitigen Scheibenverbundes zu denen des außenseitigen Scheibenverbundes versetzt angeordnet. Es empfiehlt sich auch, die elektrischen Leitungen für diese zweite Solarzellenanordnung auf dieselbe oder eine ähnliche Weise aus dem Scheibenverbund hinauszuführen, wie es für den außenseitigen Scheibenverbund schon erläutert ist. Bei einer derartigen Ausführungsform wird allenfalls die zum Gebäudeinneren hin angeordnete Scheibe des innenseitigen Scheibenverbundes mattiert sein.

Die Außenscheibe des außenliegenden Scheibenverbundes besteht vorteilhaft aus wenigstens teilweise chemisch oder thermisch vorgespanntem Glas, wobei sich eisenarmes Weißglas als besonders geeignet erwiesen hat. Auch eine Außenscheibe aus Kunststoff ist denkbar, wodurch sich die Bruchsicherheit erhöht. Zusammen mit der hochtransparenten Gießharzschicht wird damit eine hohe Lichtdurchlässigkeit sichergestellt, so daß nicht nur die Solarzellen des außenseitigen Scheibenverbundes, sondern auch gegebenenfalls die des innenseitigen Scheibenverbundes optimal zur Energiegewinnung beitragen können.

Die Wärmedämmung wird weiter verbessert, wenn der Raum zwischen dem außenseitigen Verbund und der innenliegenden Scheibe mit einem Gas geringer Wärmeleitfähigkeit, beispielsweise mit getrockneter Luft, mit Schwefelhexafluorid oder mit einer Mischung dieser Medien, gefüllt ist.

Für die Anordnung der Solarzellen gibt es praktisch unbegrenzte Möglichkeiten. Im Hinblick auf eine optimale Energiegewinnung ist es vorteilhaft, die Solarzellen des außenseitigen Scheibenverbundes so anzuordnen, daß die Scheibenfläche im wesentlichen bedeckt ist. Dabei werden Randbereiche des Scheibenverbundes ausgenommen, in denen das dort ausschließlich befindliche Gießharz die Außenscheibe und die Innenscheibe fixiert.

Als Solarzellen können polykristalline oder amorphe Solarzellen verwendet werden, wobei in jedem Scheibenverbund jeweils ein Solarzellentyp oder eine Kombination der beiden Solarzellentypen eingebettet ist. Die Solarzellen sind dabei vorteilhaft jeweils gießharzseitig auf den Oberflächen der Scheiben angeordnet, was insbesondere für amorphe Dünnschicht-Solarzellen in Betracht kommt.

Wenn wenigstens im außenseitigen Scheibenverbund amorphe Dünnschicht-Solarzellen vorgesehen sind, die eine weitgehende Transparenz für Licht im sichtbaren Bereich aufweisen, wird der ästhetische Eindruck des Fassadenelementes weiter verbessert, jedoch müssen hinsichtlich der Energiegewinnung ggf. Einbußen hingenommen werden. Insgesamt hat das Baueement nach der Erfindung den Vorteil besonders hoher Lichtdurchlässigkeit, insbesondere dann, wenn, wie dies Gegenstand der Patentansprüche 6 und 7 ist, eine speziell ausgebildete Lichtstreuschicht vorgesehen ist.

Wenn lediglich der außenseitige Scheibenverbund vorgesehen ist, kann durch Aufbringen einer Sonnenschutz-Beschichtung auf der Innenscheibe zum Raum zwischen dem außenseitigen Verbund und der innenliegenden Scheibe die Einstrahlung des Infrarotanteils vermindert werden.

Bei jeder der beschriebenen Ausführungsformen kann auf der innenliegenden Scheibe weiterhin eine Wärmeschutz-Beschichtung aufgebracht sein.

Um die Solarzellen zum Gebäudeinneren hin optisch zu verdecken, kann auf die Oberfläche der Scheiben eine Flächenbedruckung aufgebracht werden.

Als Material für die Innenscheibe und gegebenenfalls die Scheiben des innenseitigen Scheibenverbundes ist vorgespanntes Normalglas geeignet. Innerhalb des Erfindungsgedankens können Bauelemente der erfindungsgemäßen Art auch in - ggf. werksseitig - gerahmter Form verwendet werden.

Im folgenden soll die Erfindung lediglich beispielhaft anhand der beiliegenden Zeichnungen beschrieben werden. Es zeigt
- Fig. 1: eine Schnittansicht eines Bauelementes gemäß der vorliegenden Erfindung;
- Fig. 2: eine Schnittansicht eines zweiten Ausführungsbeispieles;
- Fig. 3: eine Schnittansicht eines weiteren Ausführungsbeispieles des Bauelementes mit einem innenseitigen Scheibenverbund,
- Fig. 4: eine Schnittansicht eines vierten Ausführungsbeispieles des erfindungsgemäßen Bauelementes, bei dem auch im innenseitigen Scheibenverbund Solarzellen vorgesehen sind; und
- Fig. 5: die Vorderansicht eines erfindungsgemäßen Bauelementes.

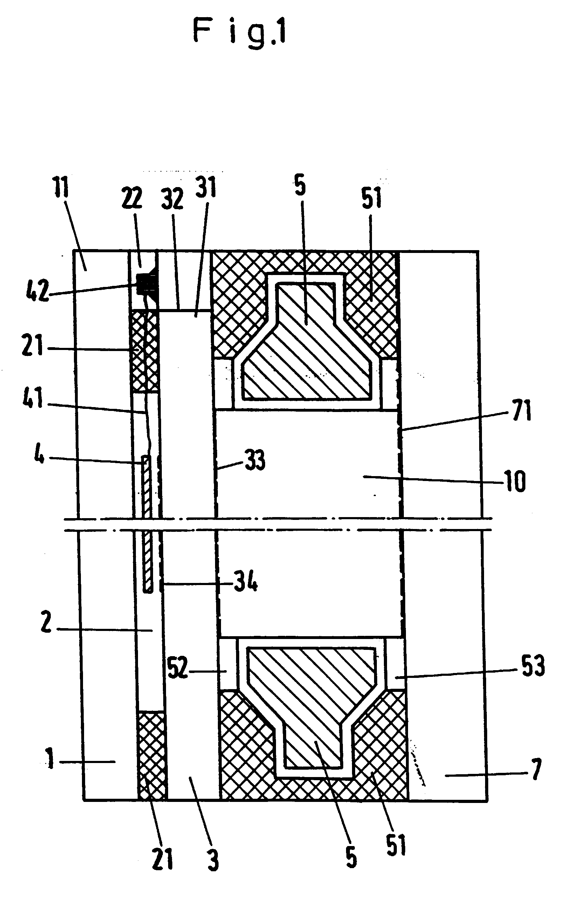

Das Bauelement von Figur 1 besteht aus einem außenseitigen Scheibenverbund, bei dem zwischen einer Außenscheibe 1 und einer Innenscheibe 3 eine Gießharzschicht 2 aus hochtransparentem Schalldämm-Gießharz vorgesehen ist. In der Gießharzschicht 2 sind Solarzellen 4 angeordnet, was hier nur schematisch angedeutet ist. Eine Randabdichtung 21 schließt die Gießharzschicht 2 ab. Im oberen Bereich 31 tritt die Innenscheibe 3 hinter den entsprechenden Bereich 11 der Außenscheibe zurück, so daß eine Ausnehmung 32 gebildet wird, die sich auch über die Gießharzschicht 2 bzw. die Randabdichtung 21 erstreckt. Durch diese Ausnehmung 32 wird die gesamte Elektrik, eingebettet in eine Klebermasse, aus dem Bauelement hinausgeführt. Dabei werden die Verbindungsleitungen 41 für die Solarzellen 4 einer gemeinsamen Sammelschiene 42 zugeführt, die innerhalb der Ausnehmung 32 liegt. Die Sammelschiene 42 kann dabei in der Klebermasse liegend oder an der Außenscheibe 1 angeordnet sein.

Dieser gesamte Kabelanschluß ist mit einer Abdeckleiste 22 versehen. Auf dem außenseitigen Scheibenverbund liegt, in Dichtleisten 52, 53 gefaßt, ein Abstandhalterrahmen 5 auf, der die Entfernung zu einer weiteren Scheibe 7 definiert, die als innenliegende Scheibe bezeichnet wird. Durch diese Anordnung wird ein Innenraum 10 gebildet, der z. B. mit getrockneter Luft oder Schwefelhexafluorid (SF₆) gefüllt ist. Eine Innenraumabdichtung bzw. Randabdichtung 51, die den Abstandhalterrahmen 5 umgibt, sorgt für einen gasdichten Abschluß des Innenraumes 10 nach außen. Der Abstandhalterrahmen 5 ist in seinen Abmessungen so gewählt, daß er die Randabdichtung 21 und den Kabelanschluß mit Abdeckleiste 22 des außenseitigen Verbundes überdeckt. Insbesondere durch die Herausführung der elektrischen Leitungen wird daher der ästhetische Gesamteindruck des Bauelementes nicht beeinträchtigt. Falls es nicht erwünscht sein sollte, daß die Solarzellen 4 vom Gebäudeinneren aus sichtbar sind, kann auf der Innenscheibe 3 gießharzseitig eine Flächenbedruckung 34 vorgesehen sein, die die Solarzellenanordnung optisch ansprechend verdeckt. Die innenliegende Scheibe 7 ist beispielsweise eine vorgespannte Einzelscheibe aus Normalglas. Auf sie ist zum Innenraum 10 hin eine Wärmeschutz-Beschichtung 71 aufgebracht. Bei dieser Ausführungsform des Bauelementes ist es vorteilhaft, wie hier geschehen, die im Innenraum 10 hingerichtete Oberfläche der Innenscheibe 3 mit einer Sonnenschutz-Beschichtung 33 zu versehen.

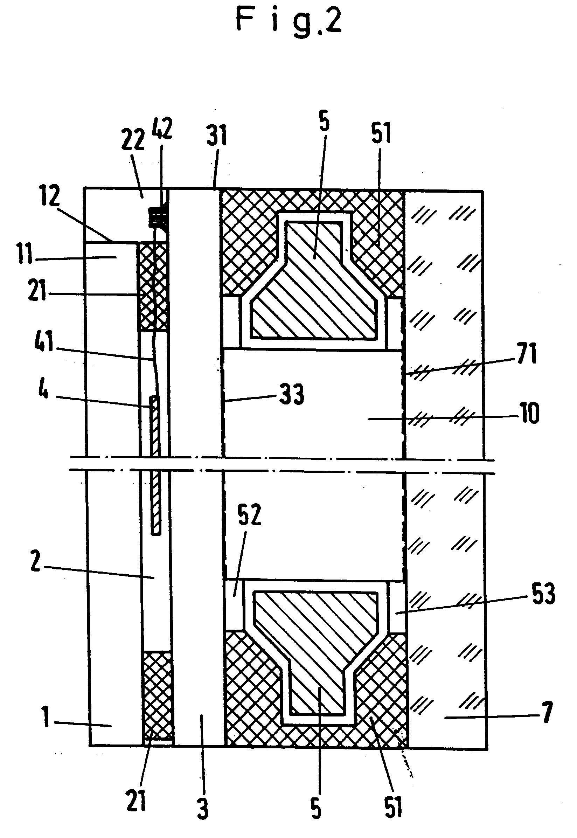

Bei dem Fassadenelement nach Figur 2 tritt die Außenscheibe im Bereich der Oberkante 11 in bezug auf die Kante 31 der Innenscheibe 3 zurück und bildet eine auch die Gießharzschicht 2 übergreifende Ausnehmung 12, in die der Kabelanschluß mit Abdeckleiste gelegt ist. Die Sammelschiene 42 ist hier unmittelbar an dem die Ausnehmung 12 begrenzenden Teil der Innenscheibe 3 angeordnet. Ansonsten entspricht diese Ausführungsform der der Figur 1, so daß auf die Beschreibung zur Figur 1 verwiesen wird. Allerdings ist als innenliegende Scheibe 7 eine solche aus mattiertem Glas vorgesehen, so daß eine Flächenbedruckung wie in Figur 1 nicht angebracht ist.

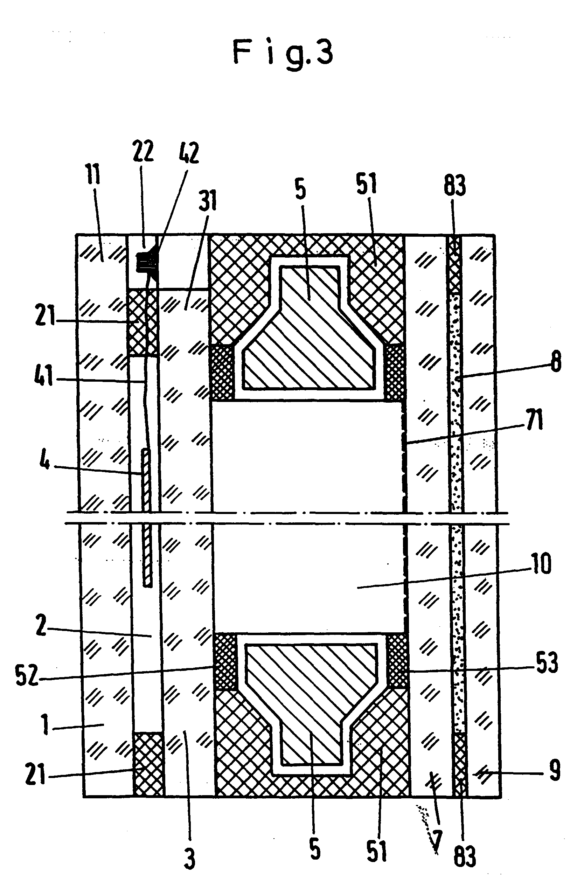

Figur 3 zeigt ein zweites Ausführungsbeispiel des Fassadenelementes gemäß der vorliegenden Erfindung, bei dem die innenliegende Scheibe 7 durch eine zwischengeschaltete Schicht 8 und eine weitere Scheibe 9 zu einem innenseitigen Scheibenverbund ergänzt ist. Die Anordnung des außenseitigen Scheibenverbundes entspricht dem der Figur 1, jedoch ist die Innenscheibe 3 weder mit einer Sonnenschutz-Beschichtung 33 noch mit einer Flächenbedruckung 34 versehen. Die Funktion dieser beiden Beschichtungen wird jetzt von der zwischengeschalteten Schicht 8 übernommen, für die ein lichtstreuendes Gießharz verwendet wird, so daß ein Milchglaseffekt erreicht wird. Die Gießharzschicht 8 ist zu den Kanten des Bauelementes hin wiederum mit Randabdichtungen 82, 83 versehen. Wie bei der zuvor beschriebenen Ausführungsform ist auf die innenliegende Scheibe 7 eine Wärmeschutz-Beschichtung 71 aufgebracht.

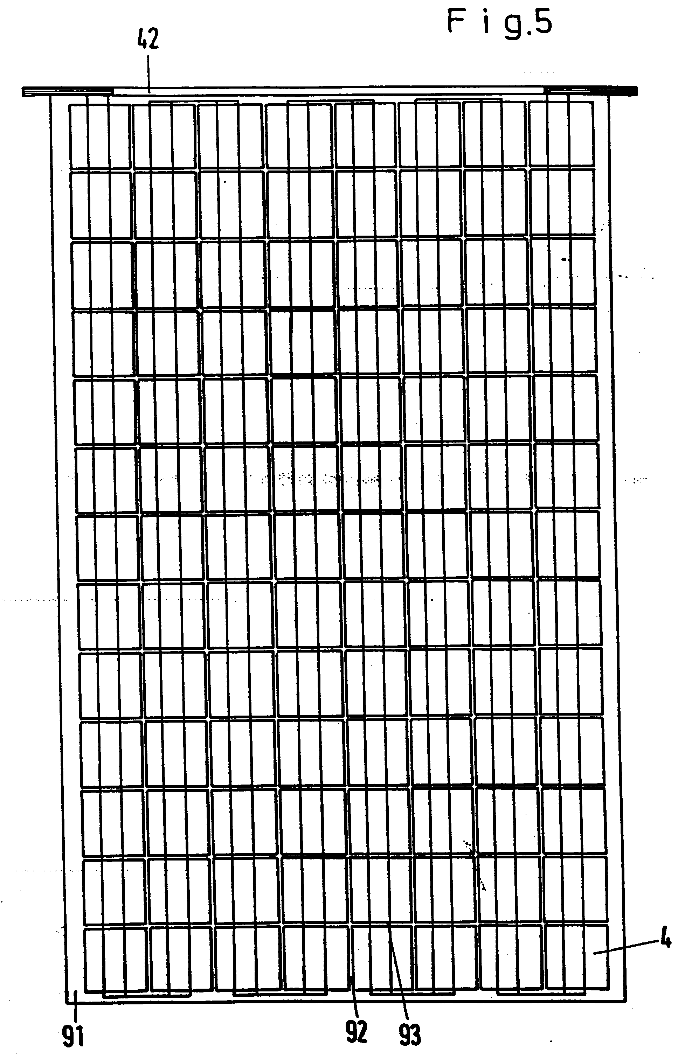

Für dieses Ausführungsbeispiel der Erfindung wird bei der Füllung mit Luft ein Wärmedurchgangswert k = 1,7 W/m²K erreicht. Die Lichtdurchlässigkeit T_{L} beträgt bei Verwendung polykristalliner Solarzellen 9%, wobei die Anordnung nach Figur 5 getroffen ist. Die Gesamtenergiedurchlässigkeit g beträgt 10%. Das bewertete Schalldämmaß Rw liegt bei 43 dB. Wenn der Innenraum mit Schwefelhexafluorid gefüllt ist, wird ein Wert von 48 dB erreicht.

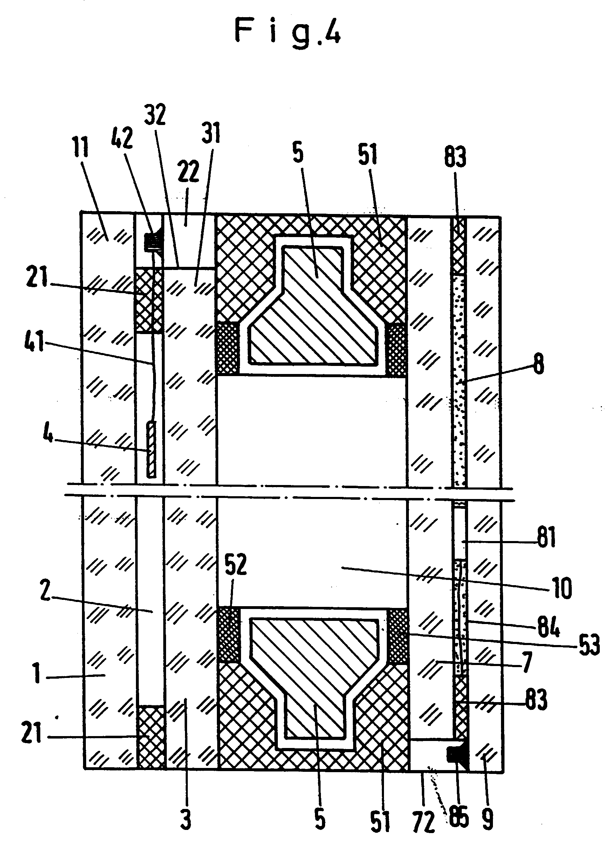

Die Ausführungsform gemäß Figur 3 kann nach Figur 4 weiter modifiziert werden, indem in die Gießharzschicht 8, wie in Figur 3 dargestellt, weitere Solarzellen 81 eingebettet werden. Diese Solarzellen können beispielsweise im unteren Bereich des Bauelementes vorgesehen sein, während die Solarzellen 4 des außenseitigen Verbundes lediglich im oberen Bereich des Bauelementes vorgesehen sind. Auch andere Anordnungen der Solarzellen 4, 81 sind denkbar, bei der sich deren jeweilige Flächen nicht überdecken. Die Verbindungsleitungen 84 für die Solarzellen 81 des innenseitigen Verbundes werden einer Sammelschiene 85 zugeführt, die, wie im Zusammenhang mit Figur 1 beschrieben, ebenfalls durch den Abstandhalterrahmen 5 optisch verdeckt ist. Wiederum ist es vorteilhaft, die innenliegende Scheibe 7 nunmehr in ihrem unteren Bereich hinter die Scheibe 9 zurücktreten lassen, so daß die Elektrik aus dem Bauelement über eine so entstehende Ausnehmung 72 hinausgeführt werden kann.

Figur 5 zeigt eine Vorderansicht auf ein erfindungsgemäßes Bauelement. Polykristalline Solarzellen 4 sind zu Einheiten der Größe 10 X 10 cm² zusammengefaßt. Die Zwischenräume 92, 93 zwischen diesen Zelleneinheiten sind lichtdurchlässig, ebenso der Randbereich 91, der das gesamte Bauelement umgibt. Die Sammelschiene 42 an der Oberseite des Bauelements faßt die Elektrik zusammen.

Bei allen beschriebenen Ausführungsbeispielen kann der außenseitige Scheibenverbund als Alarmscheibe nach der DE-PS 36 37 989 ausgeführt sein.

### Bezugszeichenliste

- 1: Außenscheibe
- 2: Gießharzschicht
- 3: Innenscheibe
- 4: Solarzelle
- 5: Abstandhalterrahmen

- 7: innenliegende Scheibe
- 8: Gießharzschicht
- 9: Scheibe
- 10: Innenraum
- 11: Oberkante der Außenscheibe
- 12: Ausnehmung

- 21: Randabdichtung
- 22: Abdeckleiste

- 31: Oberkante der Innenscheibe
- 32: Ausnehmung
- 33: Sonnenschutz-Beschichtung
- 34: Flächenbedruckung

- 41: Verbindungsleitungen
- 42: Sammelschiene

- 51: Innenraumabdichtung, Randabdichtung
- 52: Dichtleiste
- 53: Dichtleiste

- 71: Wärmeschutz-Beschichtung
- 72: Ausnehmung

- 81: Solarzelle
- 83: Randabdichtung
- 84: Verbindungsleitungen
- 85: Sammelschiene

- 91: Randbereich
- 92: Zellenzwischenraum
- 93: Zellenzwischenraum

## Patentansprüche

1. Bauelement, insbesondere Fassadenelement, mit einem außenseitigen Scheibenverbund, bei dem zwischen einer Außenscheibe und einer Innenscheibe Solarzellen angeordnet sind, und mit einer weiteren innenliegenden Scheibe, die mittels eines einen Innenraum definierenden Abstandhalterrahmens in einem Abstand zum Scheibenverbund vorgesehen ist, dadurch gekennzeichnet, daß die Solarzellen (4) in einer Gießharzschicht (2) eingebettet sind und daß die Innenscheibe (3) in ihren Abmessungen im Bereich wenigstens einer Kante (31) wenigstens teilweise in bezug auf die entsprechende Kante (11) der Außenscheibe (1) zurücktritt und so eine auch die Gießharzschicht (2) übergreifende Ausnehmung (32) bildet, durch die die notwendigen elektrischen Leitungen (42) geführt sind, wobei die Ausnehmung (32) zum Innenbereich des Bauelements hin von dem Abstandhalterrahmen (5) und einer Innenraumabdichtung (51) abgedeckt ist.

2. Bauelement, insbesondere Fassadenelement, mit einem außenseitigen Scheibenverbund, bei dem zwischen einer Außenscheibe und einer Innenscheibe Solarzellen angeordnet sind, und mit einer weiteren innenliegenden Scheibe, die mittels eines einen Innenraum definierenden Abstandhalterrahmens in einem Abstand zum Scheibenverbund vorgesehen ist, dadurch gekennzeichnet, daß die Solarzellen (4) in einer Gießharzschicht (2) eingebettet sind und daß die Außenscheibe (1) in ihren Abmessungen im Bereich wenigstens einer Kante (11) wenigstens teilweise in bezug auf die entsprechende Kante (31) der Innenscheibe (3) zurücktritt und so eine auch die Gießharzschicht (2) übergreifende Ausnehmung (12) bildet, durch die die notwendigen elektrischen Leitungen (42) geführt sind, wobei die Ausnehmung (12) zum Innenbereich des Bauelements hin von dem Abstandhalterrahmen (5) und einer Innenraumabdichtung (51) abgedeckt ist.

3. Bauelement nach Anspruch 1 oder 2, dadurch gekennzeichnet, daß die innenliegende Scheibe (7) durch eine zweite Scheibe (9) mit einer zwischengeschalteten Schicht (8) aus vorzugsweise schalldämmendem Gießharz zu einem innenseitigen Scheibenverbund ergänzt ist.

4. Bauelement nach Anspruch 3, dadurch gekennzeichnet, daß in die zwischengeschaltete Schicht (8) Solarzellen (81) eingebettet sind.

5. Bauelement nach Anspruch 4, dadurch gekennzeichnet, daß das Absorptionsmaximum für Sonnenlicht der Solarzellen (81) des innenseitigen Scheibenverbundes in einem von dem der Solarzellen (4) des außenseitigen Scheibenverbunds unterschiedlichen Spektralbereich liegt.

6. Bauelement nach einem der Ansprüche 3 bis 5, dadurch gekennzeichnet, daß die zwischengeschaltete Schicht (8) aus einem lichtstreuenden Gießharz besteht.

7. Bauelement nach Anspruch 6, dadurch gekennzeichnet, daß das lichtstreuende Gießharz der zwischengeschalteten Schicht (8) aus einem klar transparenten organischen Verbundmaterial auf Kunstharz- oder Polymerbasis und einem darin als getrennte Phase in Form flüssiger oder fester Partikel gleichmäßig dispergierten klar transparenten Lichtstreumaterial besteht, dessen Brechungsindex von demjenigen des Verbundmaterials verschieden ist, wobei zumindest ein Teil des Lichtstreumaterials aus einer in einem Monomer-/Präpolymer-System des Verbundmaterials im wesentlichen löslichen und beim Auspolymerisieren desselben zu der Verbundschicht sich zu den Lichtstreupartikeln dispergierenden Phase gebildet ist.

8. Bauelement nach einem der Ansprüche 3 bis 5, dadurch gekennzeichnet, daß die zwischengeschaltete Schicht (8) aus einem Gießharz auf Polyurethanbasis besteht, welches durch Umsetzen einer Kombination von 50 bis 65 Gew.-% eines difunktionellen Poyetherdiols mit einem Molekulargewicht von 300 bis 1200, 5 bis 20 Gew.-% eines trifunktionellen Polyesterpolyols mit einen Mokekulargewicht von 300 bis 700, wobei das Verhältnis di- zu trifunktioneller Polyole zwischen 2:1 und 5:1 liegt, und 2 bis 28 Gew.-% eines Harnstoffaddukts eines Diisocyanats, dessen Hauptbestandteil der allgemeinen Formel OCN-R-NH-CO-NH-R'-NCO entspricht, wobei R und R' gleich oder unterschiedlich sein können und ein geradkettiger, verzweigter, cyclischer oder aromatischer Kohlenwasserstoffrest mit 2 bis 18 C-Atomen sein können, sowie 2 bis 28 Gew.-% eines Diisocyanats, ausgewählt aus der Gruppe bestehend aus Diisocyanaten der allgemeinen Formel OCN-R-NCO, wobei R ein geradkettiger, verzweigter, cyclischer oder aromatischer Kohlenwasserstoffrest mit 2 - 18 C-Atomen sein kann, wobei das Verhältnis des Harnstoffaddukts zum Diisocyanat zwischen 1:0,2 und 0,2:1 variieren kann und die Summe der Gew.-%-Zahlen stets 100 ergeben soll, mit Hilfe eines Katalysators, wobei die Gießmasse ferner 0,01 bis etwa 5 Gew.-% Zusätze, wie Antioxidationsmittel, UV-Stabilisatoren und Flammschutzmittel aufweisen kann, gebildet ist.

9. Bauelement nach Anspruch 8, dadurch gekennzeichnet, daß das Gießharz der zwischengeschalteten Schicht (8) zwischen 0,001 bis 25 Gew.-% photochrome Substanzen, berechnet auf die Gesamtmenge, aufweist, vorzugsweise ausgewählt aus der Klasse der substituierten 1,3,5-Hexatriene, der substituierten 1,3-Cyclohexadiene, der substituierten Spirooxazine und/oder der substituierten Spiro (1, 8a) dihydroindolizine, wobei ggf. die Solarzellen (81) der zwischengeschalteten Schicht (8) anliegend an die dem Abstandhalterrahmen (5) zugewandte Scheibe (7) des innenliegenden Scheibenverbundes (7, 9) angeordnet sind.

10. Bauelement nach einem der vorangehenden Ansprüche, dadurch gekennzeichnet, daß die innenliegende Scheibe (7) und/oder die weitere Scheibe (9) des innenseitigen Scheibenverbundes aus mattiertem Glas besteht/bestehen.

11. Bauelement nach einem der vorangehenden Ansprüche, dadurch gekennzeichnet, daß die Außenscheibe (1) des außenseitigen Verbundes aus wenigstens teilweise chemisch oder thermisch vorgespanntem Glas besteht.

12. Bauelement nach Anspruch 11, dadurch gekennzeichnet, daß das Glas ein eisenarmes Weißglas ist.

13. Bauelement nach einem der vorangehenden Ansprüche, dadurch gekennzeichnet, daß die Außenscheibe (1) aus Kunststoff besteht.

14. Bauelement nach einem der vorangehenden Ansprüche, dadurch gekennzeichnet, daß die Gießharzschicht (2) aus einem hochtransparenten Schalldämm-Gießharz gebildet ist.

15. Bauelement nach einem der vorangehenden Ansprüche, dadurch gekennzeichnet, daß der Innenraum (10) zwischen dem außenseitigen Verbund und der innenliegenden Scheibe (7) mit Gas geringer Wärmeleitfähigkeit gefüllt ist.

16. Bauelement nach Anspruch 15, dadurch gekennzeichnet, daß das Gas getrocknete Luft, Schwefelhexafluorid oder eine Mischung dieser Medien ist.

17. Bauelement nach einem der vorangehenden Ansprüche, dadurch gekennzeichnet, daß die Solarzellen (4) des außenseitigen Scheibenverbundes die Scheibenfläche im wesentlichen bedeckend angeordnet sind.

18. Bauelement nach einem der vorangehenden Ansprüche, dadurch gekennzeichnet, daß die Solarzellen (4; 81) polykristalline oder amorphe Solarzellen sind, wobei in jedem Scheibenverbund jeweils ein Solarzellentyp oder eine Kombination der beiden Solarzellentypen vorgesehen ist.

19. Bauelement nach einem der vorangehenden Ansprüche, dadurch gekennzeichnet, daß die Solarzellen (4; 81) jeweils gießharzseitig auf den Oberflächen der Scheiben (1, 3, 7, 9) angeordnet sind.

20. Bauelement nach einem der vorangehenden Ansprüche, dadurch gekennzeichnet, daß wenigstens im außenseitigen Scheibenverbund (1, 3) amorphe Dünnschicht-Solarzellen (4) angeordnet sind, die zumindest teiltransparent sind.

21. Bauelement nach einem der vorangehenden Ansprüche, dadurch gekennzeichnet, daß auf der Innenscheibe (3) zum Raum (10) zwischen dem außenseitigen Verbund und der innenliegenden Scheibe (7) eine Sonnenschutz-Beschichtung (33) aufgebracht ist.

22. Bauelement nach einem der vorangehenden Ansprüche, dadurch gekennzeichnet, daß auf der innenliegenden Scheibe (7) zum Raum (10) zwischen dem außenseitigen Verbund und der innenliegenden Scheibe (7) eine Wärmeschutz-Beschichtung (71) aufgebracht ist.

23. Bauelement nach einem der vorangehenden Ansprüche, dadurch gekennzeichnet, daß die Rückseiten der Solarzellen (4; 81) durch eine auf entsprechende Scheiben (3; 9) des Verbundes aufgebrachte Flächenbedruckung (34) optisch verdeckt sind.

24. Bauelement nach einem der vorangehenden Ansprüche, dadurch gekennzeichnet, daß die Innenscheibe (3) aus vorgespanntem Normalglas besteht.

25. Bauelement nach einem der vorangehenden Ansprüche, dadurch gekennzeichnet, daß die Innenscheibe (3) des außenseitigen Scheibenverbundes aus mattiertem Glas besteht.

## Claims

1. Construction member, in particular a facade member, with an outside composite pane arrangement, in which solar cells are disposed between an outer pane and an inner pane, and with an additional internal pane, which is provided at a spacing from the composite pane arrangement by means of a spacer frame defining an interior space, characterised in that the solar cells (4) are embedded in a cast-resin layer (2), and that the dimensions of the inner pane (3) are at least partly reduced in the region of at least one edge (31) in relation to the corresponding edge (11) of the outer pane (1) so as to form a recess (32) which also extends over the cast-resin layer (2) and through which the necessary electrical lines (42) are run, the recess (32) being covered towards the inner region of the construction member by the spacer frame (5) and an interior space seal (51).

2. Construction member, in particular a facade member, with an outside composite pane arrangement, in which solar cells are disposed between an outer pane and an inner pane, and with an additional internal pane, which is provided at a spacing from the composite pane arrangement by means of a spacer frame defining an interior space, characterised in that the solar cells (4) are embedded in a cast-resin layer (2), and that the dimensions of the outer pane (1) are at least partly reduced in the region of at least one edge (11) in relation to the corresponding edge (31) of the inner pane (3) so as to form a recess (12) which also extends over the cast-resin layer (2) and through which the necessary electrical lines (42) are run, the recess (12) being covered towards the inner region of the construction member by the spacer frame (5) and an interior space seal (51).

3. Construction member according to claim 1 or 2, characterised in that the internal pane (7) is supplemented with a second pane (9) with an interposed layer (8), which preferably consists of sound-proof cast resin, to form an inside composite pane arrangement.

4. Construction member according to claim 3, characterised in that solar cells (81) are embedded in the interposed layer (8).

5. Construction member according to claim 4, characterised in that the maximum absorption for sunlight of the solar cells (81) of the inside composite pane arrangement lies in a spectral region which is different to that of the solar cells (4) of the outside composite pane arrangement.

6. Construction member according to one of claims 3 to 5, characterised in that the interposed layer (8) consists of a light-scattering cast resin.

7. Construction member according to claim 6, characterised in that the light-scattering cast resin of the interposed layer (8) consists of a synthetic resin- or polymer-based transparent organic composite and a transparent light-scattering material which is uniformly dispersed in the latter as a separate phase in the form of liquid or solid particles and the refractive index of which is different to that of the composite, wherein at least some of the light-scattering material is formed from a phase which is essentially soluble in a monomer/prepolymer system of the composite and which disperses to form the light-scattering particles when this system polymerises out to form the composite layer.

8. Construction member according to one of claims 3 to 5, characterised in that the interposed layer (8) consists of a polyurethane-based cast resin which is formed by reacting a combination of 50 to 65% by weight of a bifunctional polyether diol with a molecular weight of 300 to 1200, 5 to 20% by weight of a trifunctional polyester polyol with a molecular weight of 300 to 700, the ratio of bifunctional to trifunctional polyols lying between 2:1 and 5:1, and 2 to 28% by weight of a urea adduct of a diisocyanate, the main constituent of which complies with the general formula OCN-R-NH-CO-NH-R'-NCO, in which R and R' may be like or different and may be a straight-chain, branched, cyclic or aromatic hydrocarbon radical with 2 to 18 C atoms, as well as 2 to 28% by weight of a diisocyanate, selected from the group consisting of diisocyanates of the general formula OCN-R-NCO, in which R may be a straight-chain, branched, cyclic or aromatic hydrocarbon radical with 2 - 18 C atoms, wherein the ratio of urea adduct to diisocyanate may vary between 1:0.2 and 0.2:1 and the sum of the percentages by weight should always be 100, with the aid of a catalyst, and wherein the casting material may also comprise 0.01 to approximately 5% by weight of additives such as antioxidants, UV stabilisers and flame retardants.

9. Construction member according to claim 8, characterised in that the cast resin of the interposed layer (8) comprises between 0.001 and 25% by weight of photochromic substances, calculated on the basis of the overall quantity, preferably selected from the substituted 1,3,5-hexatriene, the substituted 1,3-cyclohexadiene, the substituted spirooxazine and/or the substituted spiro (1, 8a) dihydroindolizine group, wherein the solar cells (81) of the interposed layer (8) may be disposed such that they bear against the pane (7), which faces the spacer frame (5), of the internal composite pane arrangement (7, 9).

10. Construction member according to one of the preceding claims, characterised in that the internal pane (7) and/or the additional pane (9) of the inside composite pane arrangement consist(s) of frosted glass.

11. Construction member according to one of the preceding claims, characterised in that the outer pane (1) of the outside composite arrangement consists of glass which is at least partly chemically or thermally toughened.

12. Construction member according to claim 11, characterised in that the glass is a white glass with a low iron content.

13. Construction member according to one of the preceding claims, characterised in that the outer pane (1) consists of plastic.

14. Construction member according to one of the preceding claims, characterised in that the cast-resin layer (2) is formed from a highly transparent sound-proof cast resin.

15. Construction member according to one of the preceding claims, characterised in that the interior space (10) between the outside composite arrangement and the internal pane (7) is filled with a gas of a low thermal conductivity.

16. Construction member according to claim 15, characterised in that the gas is dried air, sulphur hexafluoride or a mixture of these media.

17. Construction member according to one of the preceding claims, characterised in that the solar cells (4) of the outside composite pane arrangement are disposed so as to substantially cover the pane surface.

18. Construction member according to one of the preceding claims, characterised in that the solar cells (4; 81) are polycrystalline or amorphous solar cells, one solar cell type or a combination of both solar cell types being provided in each composite pane arrangement.

19. Construction member according to one of the preceding claims, characterised in that the solar cells (4; 81) are in each case disposed on the surfaces of the panes (1, 3, 7, 9) on the cast resin side.

20. Construction member according to one of the preceding claims, characterised in that amorphous thin-film solar cells (4), which are at least semitransparent, are disposed at least in the outside composite pane arrangement (1, 3).

21. Construction member according to one of the preceding claims, characterised in that a shading coating (33) is applied to the inner pane (3) towards the space (10) between the outside composite arrangement and the internal pane (7).

22. Construction member according to one of the preceding claims, characterised in that a heat insulating coating (71) is applied to the internal pane (7) towards the space (10) between the outside composite arrangement and the internal pane (7).

23. Construction member according to one of the preceding claims, characterised in that the backs of the solar cells (4; 81) are concealed by a surface print (34) applied to corresponding panes (3; 9) of the composite arrangement.

24. Construction member according to one of the preceding claims, characterised in that the inner pane (3) consists of toughened ordinary glass.

25. Construction member according to one of the preceding claims, characterised in that the inner pane (3) of the outside composite pane arrangement consists of frosted glass.

## Revendications

1. Élément de construction, en particulier élément de façade, comprenant une combinaison extérieure de vitres, dans laquelle des cellules solaires sont disposées entre une vitre extérieure et une vitre intérieure, et comprenant une vitre intérieure supplémentaire qui, au moyen d'un cadre d'écartement définissant un espace intérieur se trouve à distance de la combinaison de vitres, caractérisé en ce que les cellules solaires (4) sont noyées dans une couche de résine de coulée (2), et en ce que, sur le plan de ses dimensions, la vitre intérieure (3) présente, dans la zone d'au moins un bord (31), un retrait au moins partiel par rapport au bord correspondant (11) de la vitre extérieure (1) et forme ainsi un évidement (32) qui recouvre également la couche de résine de coulée (2) et par lequel passent les lignes électriques nécessaires (42), l'évidement (32) étant masqué en direction de la zone intérieure de l'élément de construction par le cadre d'écartement (5) et par un moyen d'étanchéité d'espace intérieur (51).

2. Élément de construction, en particulier élément de façade, comprenant une combinaison extérieure de vitres, dans laquelle des cellules solaires sont disposées entre une vitre extérieure et une vitre intérieure, et comprenant une vitre intérieure supplémentaire qui, au moyen d'un cadre d'écartement définissant un espace intérieur se trouve à distance de la combinaison de vitres, caractérisé en ce que les cellules solaires (4) sont noyées dans une couche de résine de coulée (2), et en ce que, sur le plan de ses dimensions, la vitre extérieure (1) présente, dans la zone d'au moins un bord (11), un retrait au moins partiel par rapport au bord correspondant (31) de la vitre intérieure (3) et forme ainsi un évidement (12) qui recouvre également la couche de résine de coulée (2) et par lequel passent les lignes électriques nécessaires (42), l'évidement (12) étant masqué en direction de la zone intérieure de l'élément de construction par le cadre d'écartement (5) et par un moyen d'étanchéité d'espace intérieur (51).

3. Élément de construction selon la revendication 1 ou 2, caractérisé en ce que la vitre en position intérieure (7) est complétée par une deuxième vitre (9) avec une couche intercalée (8) en résine de coulée de préférence insonore pour former une combinaison intérieure de vitres.

4. Élément de construction selon la revendication 3, caractérisé en ce que des cellules solaires (81) sont noyées dans la couche intercalée (8).

5. Élément de construction selon la revendication 4, caractérisé en ce que le maximum d'absorption en lumière solaire des cellules solaires (81) de la combinaison intérieure de vitres se trouve dans un domaine spectral différent de celui des cellules solaires (4) de la combinaison extérieure de vitres.

6. Élément de construction selon l'une des revendications 3 à 5, caractérisé en ce que la couche intercalée (8) est réalisée dans une résine de coulée à dispersion lumineuse.

7. Élément de construction selon la revendication 6, caractérisé en ce que la résine de coulée à dispersion lumineuse de la couche intercalée (8) est constituée d'un matériau composite organique transparent clair à base de résine synthétique ou de polymère et d'un matériau de dispersion lumineuse transparent clair qui y est dispersé sous forme de phase séparée constituée de particules liquides ou solides et dont l'indice de réfraction est différent de celui du matériau composite, au moins une partie du matériau de dispersion lumineuse étant formée par une phase qui est sensiblement soluble dans un système monomère/prépolymère du matériau composite et qui, lorsque celui-ci se polymérise pour former la couche composite, se disperse en particules de dispersion lumineuse.

8. Élément de construction selon l'une des revendications 3 à 5, caractérisé en ce que la couche intercalée (8) est constituée de résine de coulée à base de polyuréthanne qui est formée par la réaction d'une combinaison de 50 à 65 % en poids d'un polyétherdiol difonctionnel avec un poids moléculaire de 300 à 1 200, de 5 à 20 % en poids d'un polyesterpolyol trifonctionnel avec un poids moléculaire de 300 à 700, le rapport entre les polyols difonctionnel et trifonctionnel étant compris entre 2/1 et 5/1, et de 2 à 28 % en poids d'un produit d'addition urique d'un diisocyanate, dont la composante principale correspond à la formule générale OCN-R-NH-CO-NH-R'-NCO, R et R' pouvant être identiques ou différents et pouvant être un reste hydrocarboné à chaîne rectiligne, ramifié, cyclique ou aromatique avec 2 à 18 atomes de C, ainsi que de 2 à 28 % en poids d'un diisocyanate, choisi dans le groupe composé de diisocyanates de formule générale OCN-R-NCO, R pouvant être un reste hydrocarboné à chaîne rectiligne, ramifié, cyclique ou aromatique avec 2 à 18 atomes de C, le rapport entre le produit d'addition urique et le diisocyanate pouvant varier entre 1/0,2 et 0,2/1 et la somme des pourcentages en poids devant toujours être égale à 100, à l'aide d'un catalyseur, la masse de coulée pouvant comporter en plus de 0,01 à environ 5 % en poids d'additifs tels que agents antioxydants, stabilisants UV et retardateurs de flammes.

9. Élément de construction selon la revendication 8, caractérisé en ce que la résine de coulée de la couche intercalée (8) comporte, par rapport à la quantité totale, entre 0,001 et 25 % en poids de substances photosensibles, de préférence choisies dans la classe des 1,3,5-hexatriènes substitués, des 1,3-cyclohexadiènes substitués, des spirooxazines substitués et/ou des spiro(1,8a)dihydroindolizines substituées, les cellules solaires (81) de la couche intercalée (8) étant éventuellement appliquées contre la vitre (7) qui est tournée vers le cadre d'écartement (5) et qui appartient à la combinaison de vitres en position intérieure (7, 9).

10. Élément de construction selon l'une des revendications précédentes, caractérisé en ce que la vitre en position intérieure (7) et/ou la vitre supplémentaire (9) de la combinaison intérieure de vitres est/sont en verre maté.

11. Élément de construction selon l'une des revendications précédentes, caractérisé en ce que la vitre extérieure (1) de la combinaison extérieure est réalisée dans un verre au moins partiellement trempé chimiquement ou thermiquement.

12. Élément de construction selon la revendication 11, caractérisé en ce que le verre est un verre blanc pauvre en fer.

13. Élément de construction selon l'une des revendications précédentes, caractérisé en ce que la vitre extérieure (1) est en matière plastique.

14. Élément de construction selon l'une des revendications précédentes, caractérisé en ce que la couche de résine de coulée (2) est réalisée en résine de coulée insonore très transparente.

15. Élément de construction selon l'une des revendications précédentes, caractérisé en ce que l'espace intérieur (10) compris entre la combinaison extérieure et la vitre en position intérieure (7) est rempli de gaz à faible conductibilité thermique.

16. Élément de construction selon la revendication 15, caractérisé en ce que le gaz est de l'air séché, de l'hexafluorure de soufre et un mélange de ces milieux.

17. Élément de construction selon l'une des revendications précédentes, caractérisé en ce que les cellules solaires (4) de la combinaison extérieure de vitres sont disposées de façon à recouvrir pour l'essentiel la surface vitrée.

18. Élément de construction selon l'une des revendications précédentes, caractérisé en ce que les cellules solaires (4 ; 81) sont des cellules solaires polycristallines ou amorphes, un seul type de cellule solaire ou une combinaison des deux types de cellules solaires étant prévus dans chaque combinaison de vitres.

19. Élément de construction selon l'une des revendications précédentes, caractérisé en ce que les cellules solaires (4 ; 81) sont disposées côté résine de coulée sur la surface des vitres (1, 3, 7, 9).

20. Élément de construction selon l'une des revendications précédentes, caractérisé en ce qu'au moins dans la combinaison extérieure de vitres (1, 3) sont disposées des cellules solaires amorphes à couche mince (4) qui sont au moins partiellement transparentes.

21. Élément de construction selon l'une des revendications précédentes, caractérisé en ce qu'un revêtement antisolaire (33) est appliqué sur la vitre intérieure (3) vers l'espace (10) compris entre la combinaison extérieure et la vitre en position intérieure (7).

22. Élément de construction selon l'une des revendications précédentes, caractérisé en ce qu'un revêtement calorifuge (71) est appliqué sur la vitre en position intérieure (7) vers l'espace (10) compris entre la combinaison extérieure et la vitre en position intérieure (7).

23. Élément de construction selon l'une des revendications précédentes, caractérisé en ce que la face arrière des cellules solaires (4 ; 81) est masquée de manière esthétique par une impression de surface (34) appliquée sur des vitres correspondantes (3 ; 9) de la combinaison.

24. Élément de construction selon l'une des revendications précédentes, caractérisé en ce que la vitre intérieure (3) est réalisée en verre ordinaire trempé.

25. Élément de construction selon l'une des revendications précédentes, caractérisé en ce que la vitre intérieure (3) de la combinaison extérieure de vitres est réalisée en verre maté.
